# EUROPEAN PATENT APPLICATION

(11) **EP 4 739 034 A1**
(43) Date of publication of application: **06.05.2026**
(21) Application number: 25180185.8
(22) Date of filing: 02.06.2025
(51) Int. Cl.: H10D 89/60

(54) **SEMICONDUCTOR DEVICE**

(30) Priority: 31.10.2024 KR 20240152722
(71) Applicant: Samsung Electronics Co., Ltd., Suwon-si, Gyeonggi-do 16677 (KR)
(72) Inventor: YOO, Jae-Hyun, 16677 Suwon-si (KR); PARK, Yonghee, 16677 Suwon-si (KR); PARK, So Ra, 16677 Suwon-si (KR); SHIN, Dong-Gwan, 16677 Suwon-si (KR)
(74) Representative: Marks & Clerk LLP

(57) **Abstract**

A semiconductor device includes a substrate including a logic cell region and an ESD cell region, a plurality of active fins on the ESD cell region, disposed alternately in a first direction, including first active fins and second active fins disposed alternately and spaced apart in the first direction, a device isolation layer defining the first and second active fins, a pair of source/drain patterns on each of the plurality of active fins, spaced apart from each other in a second direction intersecting the first direction, a channel pattern between the pair of source/drain patterns, and a gate electrode extending in the first direction on the channel pattern, wherein each of the first and second active fins extending in the second direction, and a length of the first active fin in the second direction is greater than a length of the second active fin in the second direction.

## Description

### BACKGROUND

Some example embodiments relate to a semiconductor device, and more specifically, to a semiconductor device including an ESD device (Electro-Static Discharge device or Electro-Static Discharge cell) having a fin pattern, and/or a method of fabricating the same.

Semiconductor devices are widely used in the electronics industry because of their small sizes, multi-functional characteristics, and/or low manufacturing costs. Semiconductor devices may be categorized as one of semiconductor memory devices for storing logical data, semiconductor logic devices for processing logical data, and hybrid semiconductor devices having both the functions of the semiconductor memory devices and the functions of the semiconductor logic devices.

As high-speed and/or low-power electronic devices have been in demand, high-speed and/or low-voltage semiconductor devices used therein have also been in demand, and highly integrated semiconductor devices have been pursued to satisfy these demands. However, as the integration densities of semiconductor devices increase, electrical characteristics and/or production yields of the semiconductor devices may be reduced. Thus, techniques for improving electrical characteristics and/or production yields of semiconductor devices have been variously studied.

Due to build-up of electrostatic charges in semiconductor devices, relatively high voltages may be generated near integrated circuits. The high voltages may be generated by input or output buffers of the integrated circuit, and/or by a person touching a package pin electrically connected to the input or output buffer (e.g., through the triboelectric effect). When electrostatic charges are discharged, relatively high currents may be generated at the input and output nodes of the integrated circuit. Such electrostatic discharge (ESD) may destroy or damage the entire integrated circuit. Accordingly, the research has been conducted to electrically ground the current caused by electrostatic discharge of semiconductor devices so as to reduce or mitigate such damage.

At least some of the above and other features of the invention are set out in the claims.

### SUMMARY

According to some example embodiments, a semiconductor device with improved reliability and/or yield may be provided.

Problems solved or improve upon by example embodiments are not limited to the problems mentioned above, and other problems not mentioned may be clearly understood by those of ordinary skill in the art from the description below.

A semiconductor device according to some example embodiments may include a substrate including a logic cell region and an ESD cell region, a plurality of active fins on the ESD cell region, the plurality of active fins alternating in a first direction, including first active fins and second active fins alternating and spaced apart in the first direction, a device isolation layer defining the first active fins and the second active fins, a pair of source/drain patterns on each of the plurality of active fins, spaced apart from each other in a second direction intersecting the first direction, a channel pattern between the pair of source/drain patterns, and a gate electrode extending in the first direction on the channel pattern. Each of the first and second active fins extending in the second direction, and a length of the first active fin in the second direction is greater than a length of the second active fin in the second direction.

Alternatively or additionally a semiconductor device according to some example embodiments may include a substrate including an ESD cell region, a plurality of active fins on the ESD cell region and spaced apart from each other in a first direction, a device isolation layer defining each of the plurality of active fins, a pair of source/drain patterns on each of the plurality of active fins and spaced apart from each other in a second direction intersecting the first direction, a channel pattern between the pair of source/drain patterns, and a gate electrode extending in the first direction on the channel pattern. The plurality of active fins include first active fins and second active fins, and at least one of the second active fins is between the first active fins.

Alternatively or additionally, a semiconductor device according to some example embodiments may include a substrate including a logic cell region and an ESD cell region, a first active pattern and a second active pattern on the ESD cell region, alternating in a first direction, and extending in a second direction intersecting the first direction, a device isolation layer on the ESD cell region and defining the first active pattern and the second active pattern, a channel pattern on the first active pattern, including a first semiconductor pattern and a second semiconductor pattern stacked and spaced apart from each other, a pair of source/drain patterns connected to the channel pattern and spaced apart from each other in the second direction, a gate electrode between the first and second semiconductor patterns, including a first inner electrode interposed between the first active pattern and the first semiconductor pattern, a second inner electrode interposed between the first and second semiconductor patterns, and an outer electrode on the second semiconductor pattern, a gate insulating layer between the gate electrode and the channel pattern, a gate spacer on a sidewall of the gate electrode, a gate capping pattern on an upper surface of the gate electrode, an interlayer insulating layer covering the source/drain pattern and the gate capping pattern, an active contact penetrating the interlayer insulating layer, electrically connected to the source/drain pattern, and a gate contact penetrating the interlayer insulating layer and the gate capping pattern, electrically connected to the gate electrode. The ESD cell region includes a center region, a middle region at least partly surrounding the center region, and an edge region at least partly surrounding the middle region, and the second active pattern is not provided in a portion of the center region.

Alternatively or additionally according to some example embodiments, a method of forming a semiconductor device includes forming an electrostatic discharge (ESD) cell region on a substrate, forming a plurality of active fins on the cell region, each of the plurality of active fins spaced apart from each other in a first direction, forming a device isolation layer defining each of the plurality of active fins, forming a pair of source/drain patterns on each of the plurality of active fins and spaced apart from each other in a second direction intersecting the first direction, forming a channel pattern between the pair of source/drain patterns, and forming a gate electrode extending in the first direction on the channel pattern. The plurality of active fins include first active fins and second active fins, and at least one of the second active fins is between the first active fins.

According to some example embodiments, the forming the source/drain patterns includes epitaxially forming the source/drain patterns on each of the plurality of active fins.

According to some example embodiments, the method includes forming a first portion of a N+ emitter region, a first portion of a P+ base region, an N collector region, a second portion of the P+ base region, and a second portion of the N+ emitter region sequentially arranged in the second direction on each of the first active fins.

### BRIEF DESCRIPTION OF THE DRAWINGS

Some example embodiments will be more clearly understood from the following brief description taken in conjunction with the accompanying drawings. The accompanying drawings represent some non-limiting, example embodiments as described herein.
FIG. 1 is a schematic circuit diagram illustrating an electro-static discharge (ESD) protection circuit including a logic cell and an ESD cell.
FIG. 2 is a plan view for illustrating a semiconductor device including an ESD cell according to some example embodiments.
FIGS. 3A to 3D are cross-sectional views taken along lines A-A', B-B', C-C', and D-D' of FIG. 2, respectively.
FIGS. 3E to 3H are cross-sectional views taken along lines A-A', B-B', C-C', and D-D' of FIG. 2, respectively, and are cross-sectional views according to other embodiments of FIGS. 3A to 3D.
FIG. 4 is a plan view illustrating a semiconductor device including an ESD cell according to some example embodiments.
FIG. 5 is a cross-sectional view taken along line D-D' of FIG. 4.
FIG. 6 is a plan view illustrating a semiconductor device including an ESD cell according to some example embodiments.
FIG. 7 is a cross-sectional view taken along line D-D' of FIG. 6.
FIG. 8 is a plan view illustrating a semiconductor device including an ESD cell according to some example embodiments.
FIG. 9 is a plan view illustrating a semiconductor device including an ESD cell according to some example embodiments.
FIGS. 10A to 10D are cross-sectional views taken along lines A-A', B-B', C-C', and D-D' of FIG. 9, respectively.

### DETAILED DESCRIPTION

Hereinafter, non-limiting example embodiments of the present disclosure will be described in detail, some example embodiments will be described with reference to the attached drawings.

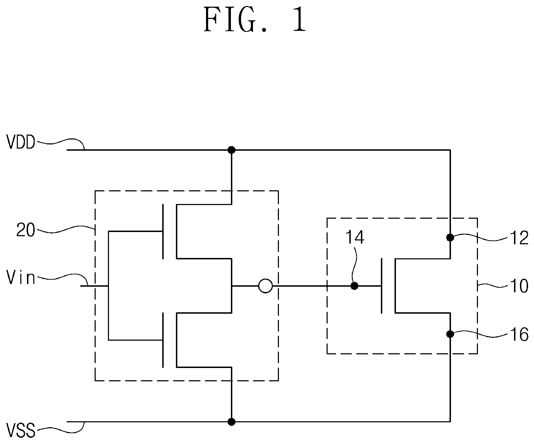

FIG. 1 is a schematic circuit diagram illustrating an electro-static discharge (ESD) protection circuit including a logic cell and an ESD cell.

Referring to FIG. 1, a semiconductor device may include an ESD cell 10 and a logic cell 20. The ESD cell 10 may be or may include a Fin Field-Effect Transistor (FinFET) used as an ESD power clamp; the logic cell 20 may be or may include at least one FinFET as well; however, example embodiments are not limited thereto. The logic cell 20 may form a trigger circuit for the ESD cell 10, and the trigger circuit may be or may include an ESD detection circuit. A drain region 12 and a source region 16 of the ESD cell 10 may be connected to a first power supply node VDD and a second power supply or voltage node VSS, respectively. Specifically, the drain region 12 may be connected to the power supply node VDD, and the source region 16 may be connected to the voltage node VSS. The voltage node VSS may be or correspond to an electrical ground such as true earth ground. An input of the logic cell 20 may be connected to a connection node Vin, and an output of the logic cell 20 may be connected to a gate 14 of the ESD cell 10.

When an ESD transient occurs on the power supply node VDD, a voltage on the connection node Vin may be lowered to, for example, 0 V. When the logic cell 20 is or includes an inverter, a gate voltage of the gate 14 of the ESD cell 10 may be a voltage sufficiently high to turn on the ESD cell 10. Accordingly, an ESD current may flow through the ESD cell 10. When the ESD transient does not occur on the power supply node VDD, a voltage on the connection node Vin may be equal to a voltage of the power supply node VDD, and a gate voltage of the gate 14 of the ESD cell 10 may be a low voltage that is turned off.

By using the trigger circuit of FIG. 1, an expectation and/or a requirement for a thickness of a gate dielectric of the transistor may be mitigated, and the gate dielectric of the ESD cell 10 may use a thin layer dielectric as thin as the gate dielectric of the FinFET device.

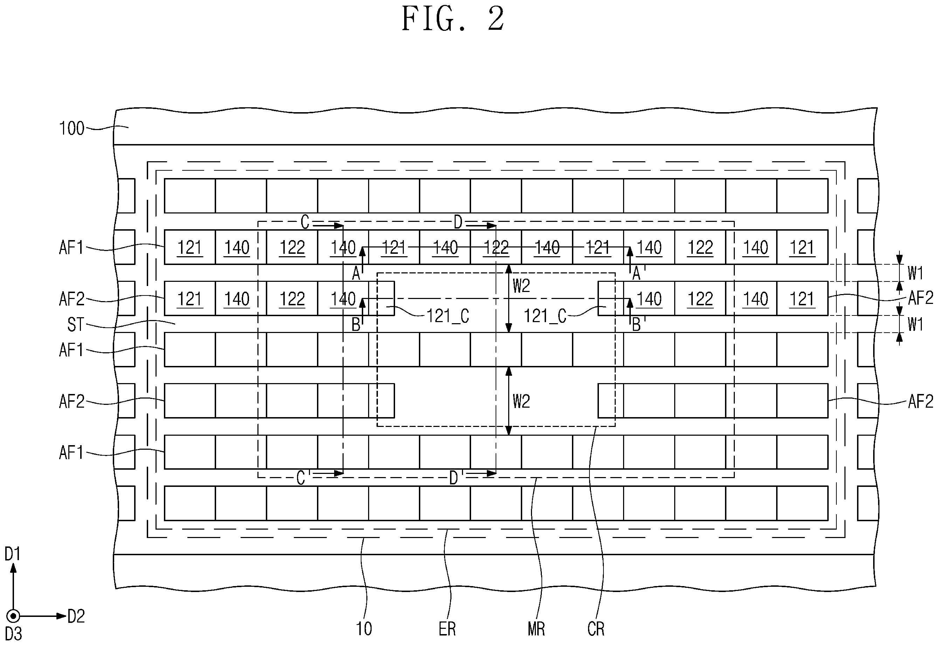

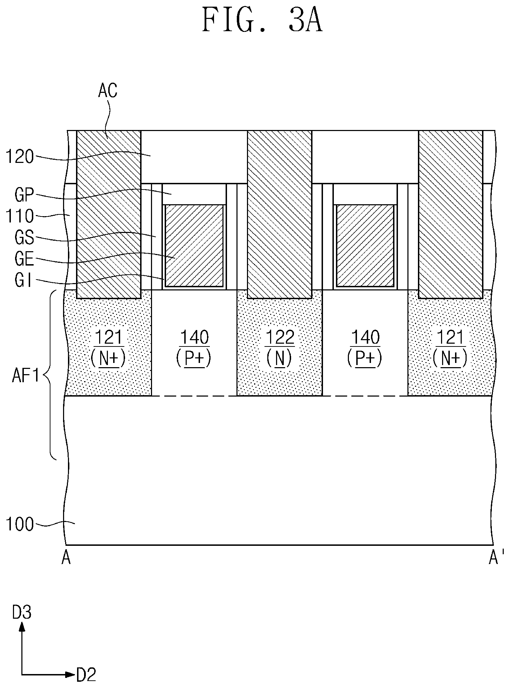

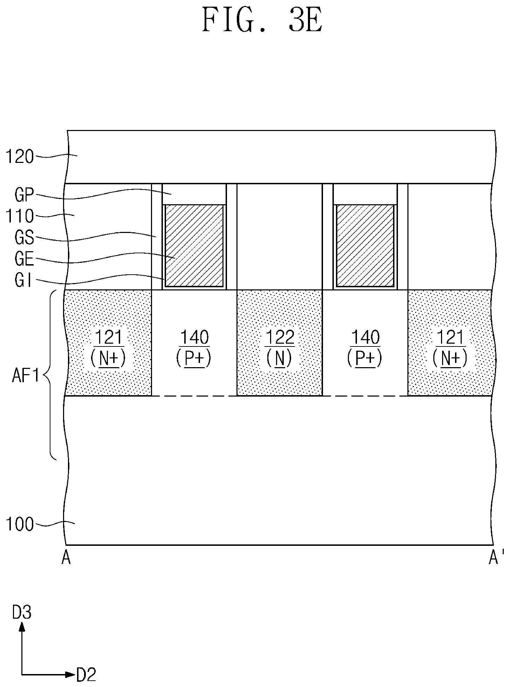

FIG. 2 is a plan view for illustrating a semiconductor device including an ESD cell according to some example embodiments. FIGS. 3A to 3D are cross-sectional views taken along lines A-A', B-B', C-C', and D-D' of FIG. 2, respectively. FIGS. 3E to 3H are cross-sectional views taken along lines A-A', B-B', C-C', and D-D' of FIG. 2, respectively, and are cross-sectional views according to other embodiments of FIGS. 3A to 3D.

Referring to FIGS. 2 and 3A to 3D, a substrate 100 including a logic cell region and an ESD cell region may be provided. The substrate 100 may be or may include a semiconductor substrate including one or more of silicon, germanium, silicon-germanium, or the like, or a compound semiconductor substrate. For example, the substrate 100 may be a silicon substrate.

The logic cell region may include logic transistors constituting or included in a logic circuit of a semiconductor device disposed thereon. In some example embodiments, the logic cell region may include an NMOSFET region and a PMOSFET region. The NMOSFET region and the PMOSFET region may include some of the logic transistors disposed thereon.

The ESD cell region may include an ESD cell 10 constituting or included in an ESD protection circuit of a semiconductor device disposed thereon. The ESD cell 10 may be or may include an active fin-based ESD device including an NPN bipolar transistor. The ESD cell 10 may include an N-type FinFET. As another example, the ESD cell 10 may include a P-type FinFET, and in this case, the ESD cell 10 may be or may include an active fin-based ESD device including a PNP bipolar transistor.

The ESD cell 10 may include a plurality of active fins AF1 and AF2. In some example embodiments, the ESD cell 10 may include a first active fin AF1 and a second active fin AF2 that are disposed alternately in a first direction D1. The first active fin AF1 and the second active fin AF2 may be spaced apart from each other in the first direction D1. An ESD conducting ability of the ESD cell 10 may be proportional to the overall channel width, e.g., the transistor width, of the ESD cell 10. For example, the ESD conducting ability of the ESD cell 10 may be increased as the number of active fins increases.

Each of the plurality of active fins AF1 and AF2 may include a first portion of an N+ emitter region 121, a first portion of a P+ base region 140, an N collector region 122, a second portion of the P+ base region 140, and a second portion of the N+ emitter region 121 sequentially disposed in a second direction D2 when viewed in a plan view. The second direction D2 may be a direction intersecting the first direction D1.

Specifically, the first portion of the N+ emitter region 121, the first portion of the P+ base region 140, the N collector region 122, the second portion of the P+ base region 140, and the second portion of the N+ emitter region 121 may be sequentially disposed in the second direction D2 on the first active fin AF1. The first portion of the N+ emitter region 121, the first portion of the P+ base region 140, the N collector region 122, the second portion of the P+ base region 140, and a second N+ emitter region 121_C may be sequentially disposed in the second direction D2 on the second active fin AF2.

When viewed in a plan view, a plurality of second active fins AF2 spaced apart at a certain interval in the second direction D2 may be disposed. One second active fin AF2 and another second active fin AF2 may be disposed to face each other in the second direction D2. Accordingly, one second active fin AF2 may include a first N+ emitter region 121, a first portion of a P+ base region 140, an N collector region 122, a second portion of the P+ base region 140, and a second N+ emitter region 121_C disposed on the second direction D2, and another second active fin AF2 (which may, in one example, be referred to as a third active fin) may include a second (e.g. a third) N+ emitter region 121_C, a second portion of a P+ base region 140, an N collector (e.g. a second N collector) region 122, a first portion of the P+ base region 140, and a first (e.g. a fourth) N+ emitter region 121 disposed in the second direction D2. A width of the second N+ emitter region 121_C in the second direction D2 may be smaller than a width of the first N+ emitter region 121 in the second direction D2.

A first width W1 between the first active fin AF1 and the second active fin AF2 may be defined as the shortest distance in the first direction D1. A second width W2 between the neighboring (e.g. adjacent) first active fins AF1 may be defined as the shortest distance in the first direction D1. In some example embodiments, one second active fin AF2 may be disposed between the neighboring first active fins AF1. The second width W2 may be greater than the first width W1. For example, the second width W2 may be 1.5 to 3.5 times the first width W1, and in some examples may be 2 to 2.5 times the first width W1.

A length of the first active fin AF1 in the second direction D2 may be greater than a length of the second active fin AF2 in the second direction D2. For example, a length of the first active fin AF1 in the second direction D2 may be 1.5 to 3.5 times a length of the second active fin AF2 in the second direction D2, and in some example embodiments may be 2 to 2.5 times the length.

The ESD cell 10 may include a center region CR, a middle region MR, and an edge region ER when viewed in a plan view. The middle region MR may be interposed between the center region CR and the edge region ER. An active fin may not be provided in a portion of the center region CR. For example, the center region CR may include a region where a portion of the active fin is removed and the active fin is not disposed.

As the active fin is not provided in or in at least some portions of the center region CR of the ESD cell 10, overcurrent flowing in the ESD cell 10 may not be concentrated in the center region CR. For example, due to a layout of the ESD cell, the overcurrent concentrated in the center region CR may be dispersed, thereby improving performance of the degraded ESD device. Alternatively or additionally, current interference phenomenon between active fins may be prevented or reduced in likelihood of occurrence and/or in impact from occurrence, thereby reducing a region where the ESD cell 10 performance is vulnerable and/or improving thermal uniformity.

Referring to FIGS. 3A to 3D, a plurality of active fins AF1 and AF2 may be defined by a trench formed on an upper portion of the substrate 100. The plurality of active fins AF1 and AF2 may be spaced apart from each other in the first direction D1 with the trench interposed therebetween. The plurality of active fins AF1 and AF2 may extend in the second direction D2. The plurality of active fins AF1 and AF2 may be vertically protruding portions and may be a portion of the substrate 100 and/or may have been grown epitaxially from the substrate 100.

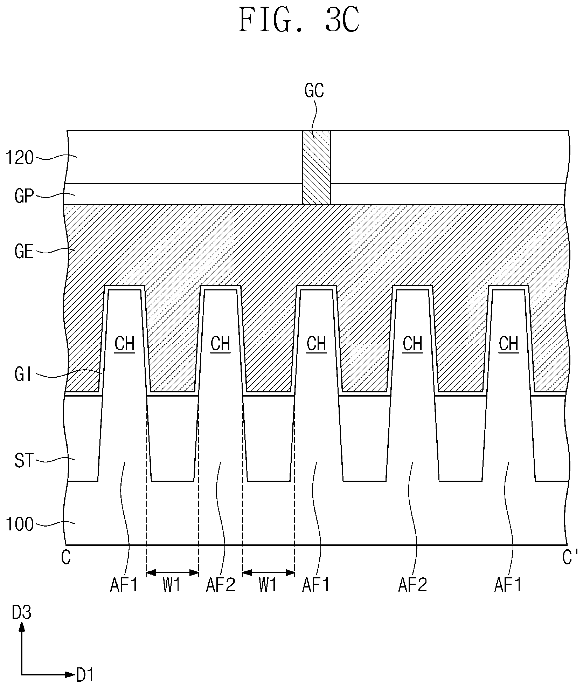

A device isolation layer ST may fill the trenches. The device isolation layer ST may include a silicon oxide layer. Upper portions of the plurality of active fins AF1 and AF2 may protrude vertically above the device isolation layer ST (refer to FIG. 3C). Each of upper portions of the plurality of active fins AF1 and AF2 may have a fin shape. The device isolation layer ST may not cover the upper portions of the plurality of active fins AF1 and AF2. The device isolation layer ST may cover lower sidewalls of the plurality of active fins AF1 and AF2. In one example, the device isolation layer ST may define the first active fins AF1 and the second active fins AF2.

Source/drain patterns 121 and 122 may be provided on the upper portions of the first active fin AF1. Recesses may be formed on the upper portions of the first active fin AF1, and the source/drain patterns 121 and 122 may fill the recesses, respectively. The source/drain patterns 121 and 122 may be impurity regions of a first conductive type (e.g., n-type). The source/drain patterns 121 and 122 may include an impurity of a first conductive type (e.g., phosphorus (P) and/or arsenic (As)). In some example embodiments, the source/drain patterns 121 and/or 122 may be counterdoped, e.g., may include both n-type impurities and p-type impurities, while a dopant concentration of n-type impurities may be much greater than (e.g., several orders of magnitude greater than) that of the p-type impurities. A channel pattern CH may be interposed between a pair of source/drain patterns 121 and 122.

Specifically, the source/drain patterns 121 and 122 may correspond to the N+ emitter region 121 and the N collector region 122 which are described above. Among the source/drain patterns 121 and 122, the N+ emitter region 121 may be a heavily doped n-type (N+) region, and the N collector region 122 among the source/drain patterns 121 and 122 may be a lightly doped n-type (N) region. A dopant concentration of n-type impurities in the N+ emitter region 121 may be orders of magnitude greater than a dopant concentration of n-type impurities in the N collector region 122; example embodiments are not limited thereto.

Source/drain patterns 121, 122, and 121_C may be provided on the upper portion of the second active fin AF2. Recesses may be formed on the upper portion of the second active fin AF2, and the source/drain patterns 121, 122, and 121_C may fill the recesses, respectively. The source/drain patterns 121, 122, and 121_C may be impurity regions of the first conductivity type (e.g., n-type). The source/drain patterns 121, 122, and 121_C may include a first conductivity type impurity (e.g., phosphorus (P) and/or arsenic (As)). A channel pattern CH may be interposed between a pair of source/drain patterns (121, 122 or 122, 121_C).

Specifically, the source/drain patterns 121, 122, and 121_C may correspond to the above-described first N+ emitter region 121, the second N+ emitter region 121_C, and the N collector region 122. Among the source/drain patterns 121, 122, and 121_C, the N+ emitter region 121 and 121_C may be a heavily doped n-type (N+) region, and among the source/drain patterns 121, 122, and 121_C, the N collector region 122 may be a lightly doped n-type (N) region.

Each of the upper portions of the active fins AF1 and AF2 vertically protruding onto the device isolation layer ST may correspond to the P+ base region 140. For example, the upper portions of the active fins AF1 or AF2 between the source/drain patterns 121, 122, and 121_C may be the P+ base region 140. Each of the upper portions of the active fins AF1 and AF2 protruding vertically onto the device isolation layer ST may be a heavily doped p-type (P+) region.

The source/drain patterns 121, 122, and 121_C may be or may include epitaxial patterns formed by a selective epitaxial growth process; in some example embodiments, there may be a seem and/or transition region between the substrate 100 and the source/drain patterns 121, 122, and 121_C, although example embodiments are not limited thereto. Upper surfaces of the source/drain patterns 121, 122, and 121_C may be positioned at a higher level than those of upper surfaces of the channel patterns CH. For example, the source/drain patterns 121, 122, and 121_C may include the same semiconductor element (e.g., Si) as the substrate 100, and/or may also include other semiconductor elements such as but not limited to germanium.

The channel patterns CH may be provided at a higher level than the device isolation layer ST. For example, the upper surface of the channel pattern CH may be higher than that of the upper surface of the device isolation layer ST (refer to FIG. 3C). The channel patterns CH according to some example embodiments may have a three-dimensional structure on the device isolation layer ST, thereby implementing a three-dimensional transistor (3D FET).

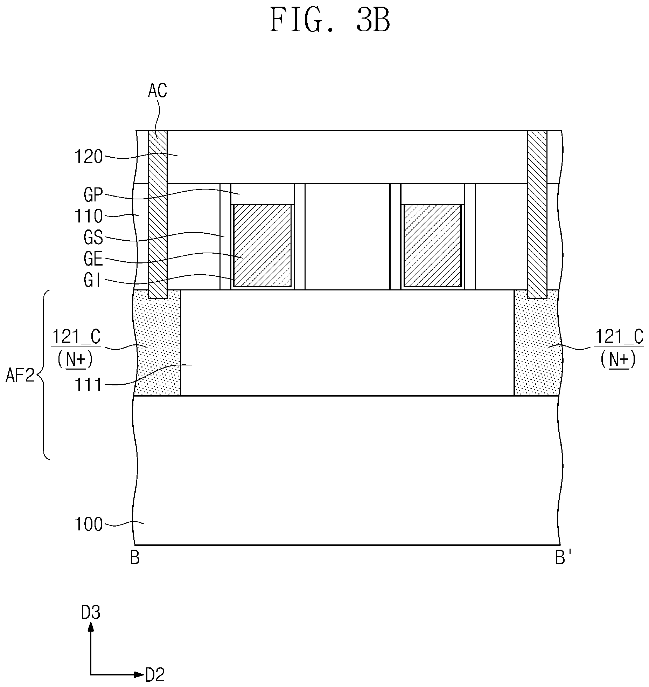

Referring to FIG. 2 and FIG. 3B, a width of the second N+ emitter region 121_C among the source/drain patterns 121, 122, and 121_C in the second direction D2 may be smaller than a width of the first N+ emitter region 121 in the second direction D2. An insulating pattern 111 may be provided between a plurality of second active fins AF2. The insulating pattern 111 may include a silicon oxide layer, and may or may not include the same material as that of the device isolation regions ST.

Gate electrodes GE extending in the first direction D1 across the first and second active fins AF1 and AF2 may be provided. The gate electrodes GE may be spaced apart from each other in the second direction D2. The gate electrodes GE may be vertically overlapped with the channel patterns CH. Each of the gate electrodes GE may be provided on the upper surface and both sidewalls of each of the channel patterns CH (refer to FIG. 3C). For example, the gate electrodes GE may include at least one of a conductive metal nitride (e.g., titanium nitride and/or tantalum nitride) and a metal material (e.g., titanium, tantalum, tungsten, copper, aluminum, and/or doped polysilicon).

A pair of gate spacers GS may be disposed on both sidewalls of each of the gate electrodes GE. The gate spacers GS may extend along the gate electrodes GE in the first direction D1. Upper surfaces of the gate spacers GS may be higher than upper surfaces of the gate electrodes GE. The upper surfaces of the gate spacers GS may be coplanar with an upper surface of a first interlayer insulating layer 110 to be described later. The gate spacers GS may include at least one of SiCN, SiCON, and SiN. In some example embodiments, the gate spacers GS may include a multi-layer formed of at least two of SiCN, SiCON, and SiN.

A gate capping pattern GP may be provided on each of the gate electrodes GE. The gate capping pattern GP may extend in the first direction D1 along the gate electrode GE. The gate capping pattern GP may include a material having etching selectivity with respect to first and second interlayer insulating layers 110 and 120 to be described later. For example, the gate capping pattern GP may include at least one of SiON, SiCN, SiCON, and SiN.

A gate dielectric layer GI may be interposed between the gate electrode GE and the first active fin AF1 and between the gate electrode GE and the second active fin AF2. The gate dielectric layer GI may extend along a bottom surface of the gate electrode GE thereon. For example, the gate dielectric layer GI may cover the upper surface and both sidewalls of the channel pattern CH.

The gate dielectric layer GI may include a high-k material having a higher dielectric constant than that of a silicon oxide layer. For example, the high-k material may include at least one of hafnium oxide, hafnium silicon oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate.

A first interlayer insulating layer 110 may be provided on the substrate 100. The first interlayer insulating layer 110 may cover the gate spacers GS and the source/drain patterns 121, 122, and 121_C. An upper surface of the first interlayer insulating layer 110 may be substantially coplanar with upper surfaces of the gate capping patterns GP and upper surfaces of the gate spacers GS. A second interlayer insulating layer 120 covering the gate capping patterns GP may be disposed on the first interlayer insulating layer 110. As an example, the first and second interlayer insulating layers 110 and 120 may include a silicon oxide layer.

Between a pair of gate electrodes GE, at least one active contact AC may be disposed to penetrate the first and second interlayer insulating layers 110 and 120 and to be electrically connected to the source/drain patterns 121, 122, and 121_C. The active contact AC may include a metal material, for example, at least one of aluminum, copper, tungsten, molybdenum, cobalt, or doped polysilicon.

A silicide layer (not shown) may be interposed between the first and second source/drain patterns 121, 122, and 121_C and the active contact AC. The active contact AC may be electrically connected to the source/drain patterns 121, 122, and 121_C through the silicide layer. The silicide layer may include a metal silicide, and may include at least one of titanium silicide, tantalum silicide, tungsten silicide, nickel silicide, and cobalt silicide, for example.

On the device isolation layer ST, at least one gate contact GC may be disposed to penetrate the second interlayer insulating layer 120 and the gate capping pattern GP and to be electrically connected to the gate electrode GE. The gate contact GC may include the same metal material as the active contact AC; example embodiments are not limited thereto.

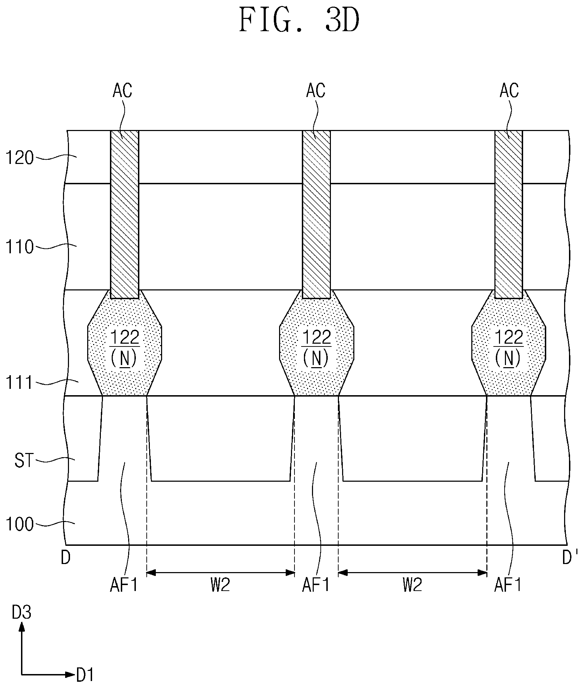

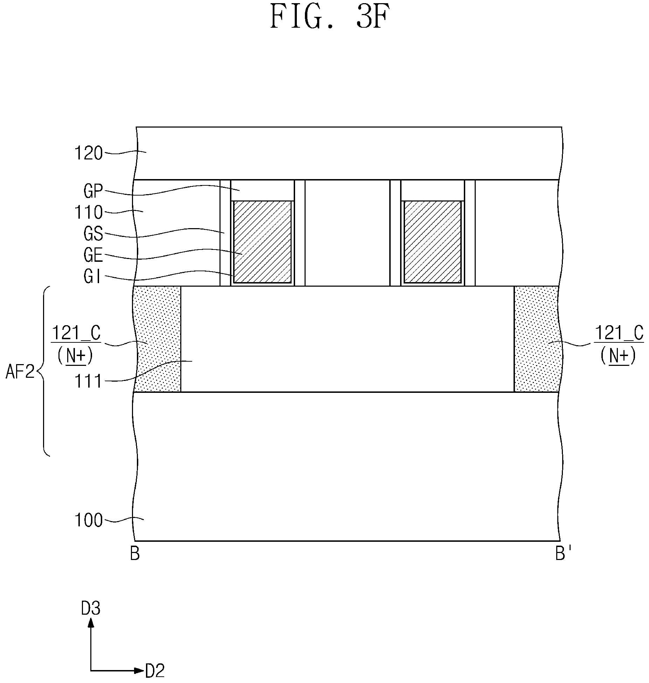

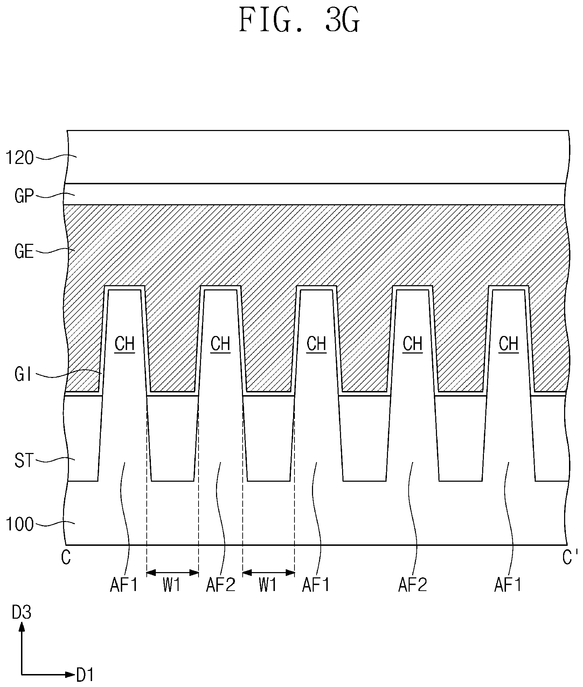

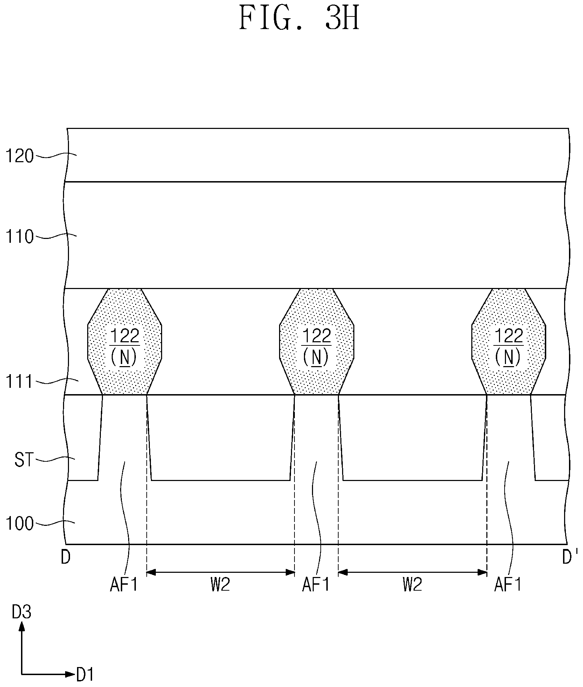

FIGS. 3E to 3H are cross-sectional views taken along lines A-A', B-B', C-C', and D-D' of FIG. 2, respectively, and are cross-sectional views according to other example embodiments of FIGS. 3A to 3D. In detail, FIG. 3E illustrates some example embodiments similar to that of FIG. 3A, and FIG. 3F illustrates some example embodiments similar to those of FIG. 3B. FIG. 3G illustrates some example embodiments similar to those of FIG. 3C, and FIG. 3H illustrates some example embodiments similar to those of FIG. 3D.

Referring to FIGS. 3E to 3H, at least one active contact that penetrates the first and second interlayer insulating layers 110 and 120 and is electrically connected to the source/drain patterns 121, 122, and 121_C may not be disposed between a pair of gate electrodes GE. In addition, at least one gate contact that penetrates the second interlayer insulating layer 120 and the gate capping pattern GP and is electrically connected to the gate electrode GE may not be disposed on the device isolation layer ST.

The ESD cell 10 may include a center region CR, a middle region MR, and an edge region ER when viewed in a plan view. An active contact connected to the source/drain patterns 121, 122, and 121_C and a gate contact connected to the gate electrode GE may not be provided in a portion of the center region CR. That is, the center region CR may include a region where the active contact or the gate contact that applies an electrical signal to the active fin is removed and the contacts are not provided.

As the contacts are not provided in the center region CR of the ESD cell 10, the overcurrent flowing in the ESD cell 10 may not be concentrated in the center region CR. For example, current may not flow to the NPN bipolar transistor in the center region CR where the contacts are not provided, and thus performance of the degraded ESD device may be improved. Alternatively or additionally, current interference phenomenon between the active fins may be prevented, thereby reducing a region where the ESD cell 10 performance is vulnerable, and improving thermal uniformity.

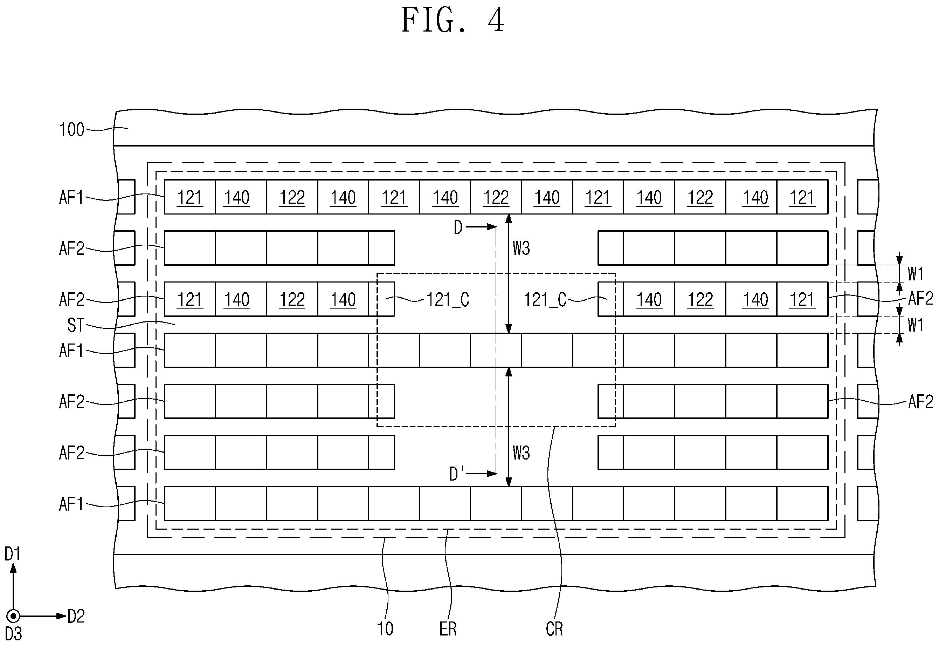

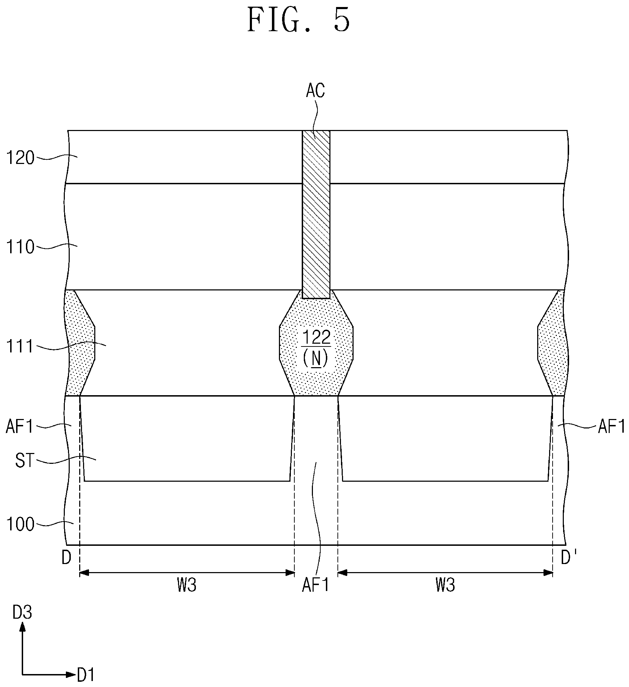

FIG. 4 is a plan view for illustrating a semiconductor device including an ESD cell according to some example embodiments. FIG. 5 is a cross-sectional view along the line D-D' of FIG. 4. For simplicity of explanation, description of the overlapping content with the above-mentioned content will be omitted, and differences from the above-mentioned content will be mainly explained.

Referring to FIGS. 4 and 5, a first width W1 between the first active fin AF1 and a second active fin AF2 or a first width W1 between the neighboring second active fins AF2 may be defined as the shortest distance in the first direction D1. A third width W3 between the neighboring first active fins AF1 may be defined as the shortest distance in the first direction D1 (see FIG. 5). In some example embodiments, two second active fins AF2 may be disposed between the neighboring first active fins AF1. The third width W3 may be greater than the first width W1. For example, the third width W3 may be 2.5 to 4.5 times greater than the first width W1, and in some examples 3 to 3.5 times greater than the first width W1. The third width W3 may be greater than the second width W2 (see FIG. 2) described above. For example, the third width W3 may be 1.5 to 2.5 times greater than the second width W2 (see FIG. 2).

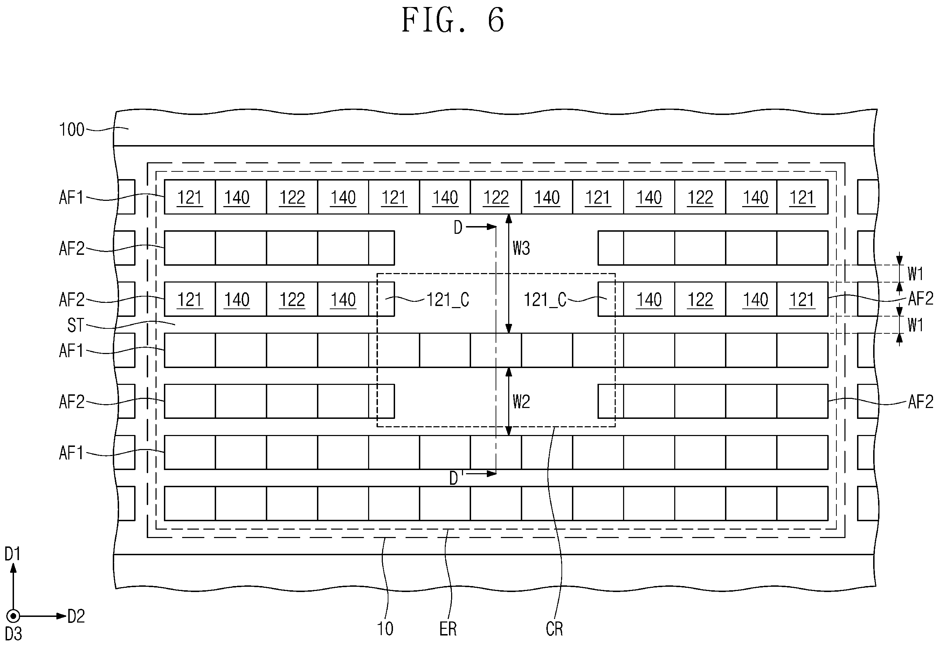

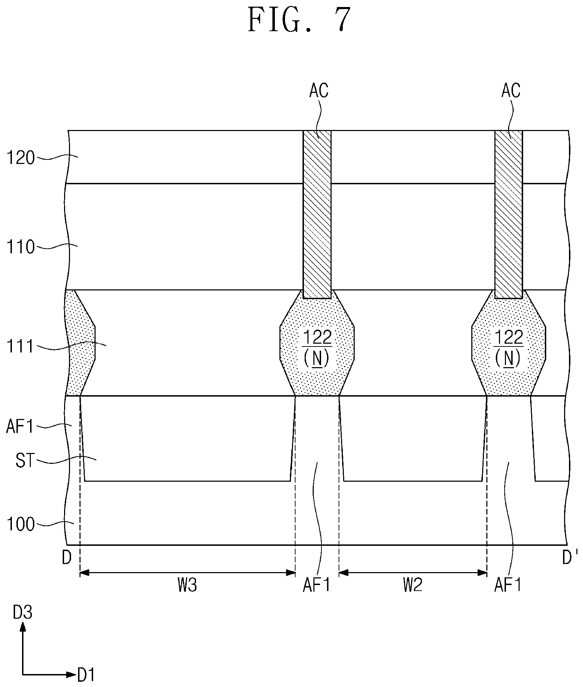

FIG. 6 is a plan view illustrating a semiconductor device including an ESD cell according to some example embodiments. FIG. 7 is a cross-sectional view taken along line D-D' of FIG. 6. For simplicity of explanation, explanation of contents overlapping with the above contents will be omitted, and differences from the above contents will be mainly explained.

Referring to FIGS. 6 and 7, a first width W1 between the first active fin AF1 and the second active fin AF2 or a first width W1 between the neighboring second active fins AF2 may be defined as the shortest distance in the first direction D1. The second width W2 between the neighboring first active fins AF1 or the third width W3 between the neighboring first active fins AF1 may be defined as the shortest distance in the first direction D1 (see FIG. 7).

In some example embodiments, two second active fins AF2 may be disposed between the neighboring first active fins AF1 or one second active fin AF2. For example, when a distance between the neighboring first active fins AF1 is the third width W3, two second active fins AF2 may be disposed between the first active fins AF1. When a distance between the neighboring first active fins AF1 is the second width W2, one second active fin AF2 may be disposed between the first active fins AF1.

The third width W3 may be greater than the first width W1 and the second width W2. The second width W2 may be greater than the first width W1. For example, the third width W3 may be 2.5 to 4.5 times the first width W1, and in some examples 3 to 3.5 times the first width W1. The third width W3 may be 1.5 to 2.5 times the second width W2.

The ESD cell 10 may include a center region CR and an edge region ER when viewed in a plan view. An active fin may not be provided in a portion of the center region CR. For example, the center region CR may include a region where some of the active fins are removed and the active fins are not disposed. The number of active fins removed for each region where the ESD device performance is vulnerable among the center region CR may be adjusted.

As the active fins are not provided in the center region CR of the ESD cell 10 or the peripheral region adjacent to the center region CR, the overcurrent flowing in the ESD cell 10 may not be concentrated in the center region CR. For example, the overcurrent concentrated in the center region CR due to the layout of the ESD cell may be dispersed, thereby improving the performance of the degraded ESD device. Alternatively or additionally, the current interference phenomenon between the active fins may be prevented or reduced, thereby reducing the region where the ESD cell 10 performance is vulnerable.

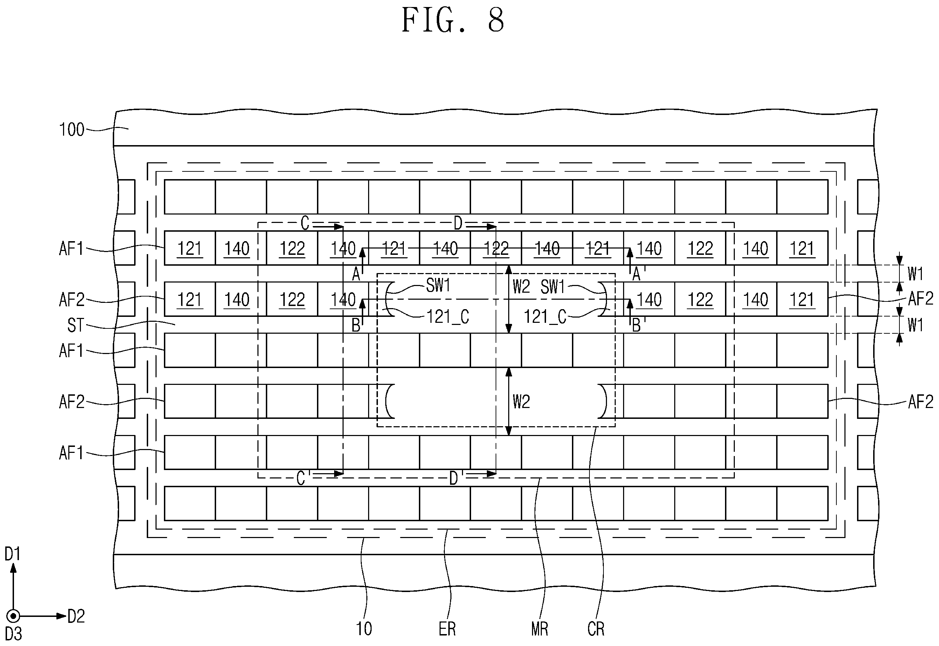

FIG. 8 is a plan view for illustrating a semiconductor device including an ESD cell according to some example embodiments. For simplicity of explanation, explanation of the overlapping content with the above-mentioned content will be omitted, and the differences from the above-mentioned content will be mainly explained.

Referring to FIG. 8, a first N+ emitter region 121, a P+ base region 140, an N collector region 122, a P+ base region 140, and a second N+ emitter region 121_C may be disposed on the second active fin AF2.

When viewed in a plan view, a plurality of second active fins AF2 spaced apart at a certain interval in the second direction D2 may be disposed. One second active fin AF2 and another second active fin AF2 may be disposed to face each other in the second direction D2. Accordingly, one second active fin AF2 may include a first N+ emitter region 121, a first portion of a P+ base region 140, an N collector region 122, a second portion of the P+ base region 140, and a second N+ emitter region 121_C in the second direction D2, and another second active fin AF2 may include a second N+ emitter region 121_C, a second portion of a P+ base region 140, an N collector region 122, a first portion of the P+ base region 140, and a first N+ emitter region 121 disposed in the second direction D2.

One sidewall SW1 of the second emitter region 121_C may have a curved shape when viewed in a plan view, e.g., a concavely curved shape. This may be a feature that appears in an etching process, such as from an isotropic etching process, in which a portion of the second active fin AF2 is removed. For example, before performing the etching process, the sidewall SW1 of the second emitter region 121_C may be formed as a curved surface on the margin of the process of forming the hard mask.

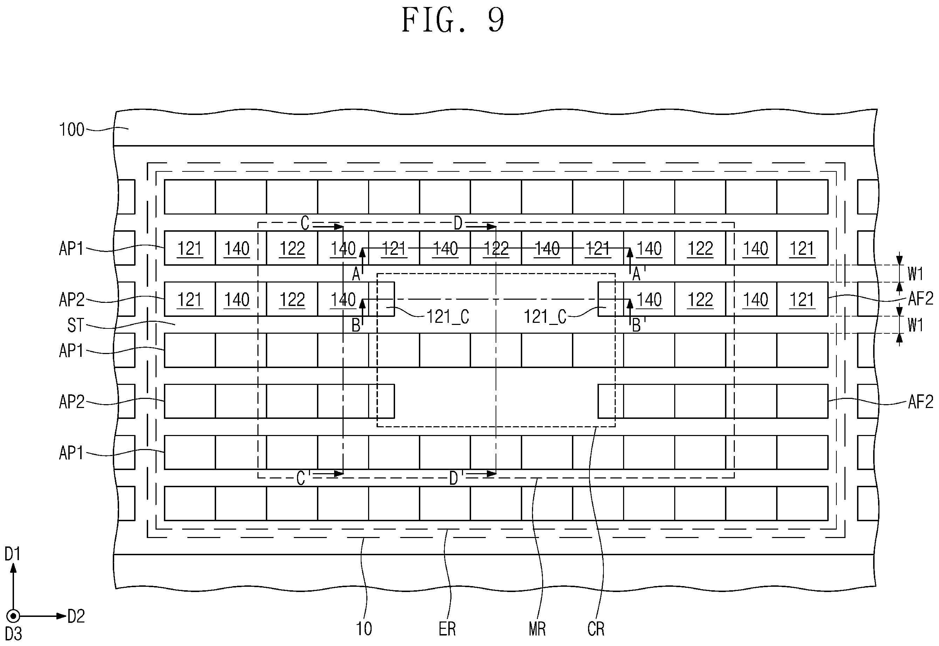

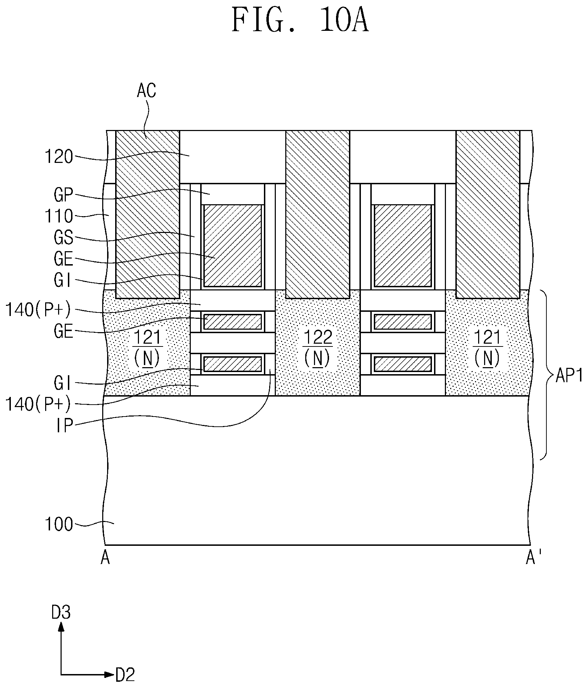

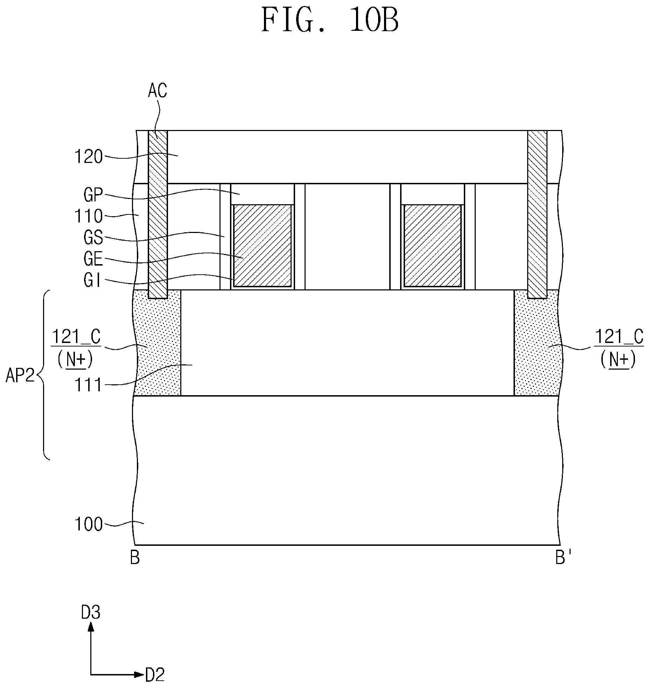

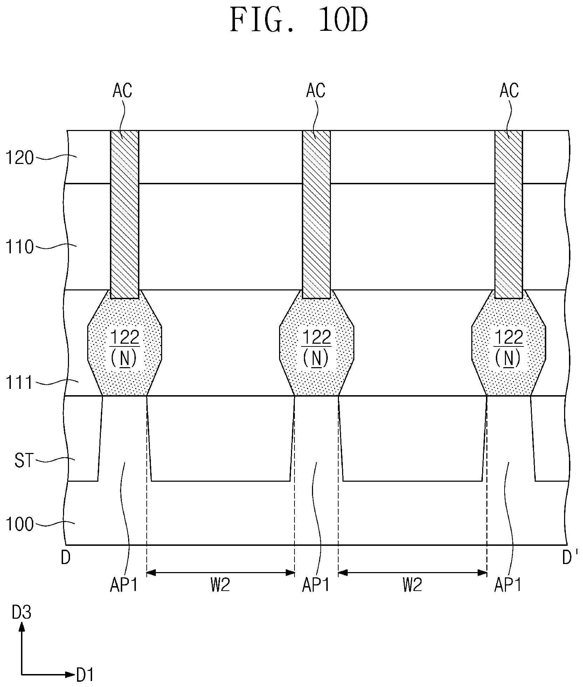

FIG. 9 is a plan view illustrating a semiconductor device including an ESD cell according to some example embodiments. FIGS. 10A to 10D are cross-sectional views taken along lines A-A', B-B', C-C', and D-D' of FIG. 9, respectively. For simplicity of explanation, descriptions of contents overlapping with the above-described contents will be omitted, and differences from the above-described contents will be mainly explained.

Referring to FIGS. 9 and 10A to 10D, a first active pattern AP1 and a second active pattern AP2 may be defined by a trench formed on an upper portion of a substrate 100. The first and second active patterns AP1 and AP2 may be disposed alternately in a first direction D1. The first and second active patterns AP1 and AP2 may extend in the second direction D2. The first and second active patterns AP1 and AP2 may be vertically protruding portions and may be a portion of the substrate 100.

A device isolation layer ST may fill the trench. The device isolation layer ST may cover a sidewall of each of the first and second active patterns AP1 and AP2. The device isolation layer ST may include a silicon oxide layer. The device isolation layer ST may not cover the channel patterns CH to be described later.

A channel pattern CH may be provided on the first active pattern AP1 and the second active pattern AP2. The channel pattern CH may include a first semiconductor pattern and a second semiconductor pattern that are sequentially stacked. The first and second semiconductor patterns may be spaced apart from each other in the vertical direction (i.e., a third direction D3).

Each of the first and second semiconductor patterns may include one or more of silicon (Si), germanium (Ge), or silicon-germanium (SiGe), and in some example embodiments may include the same material or different material. For example, each of the first and second semiconductor patterns may include crystalline silicon such as single-crystal silicon. Each of the first and second semiconductor patterns may be a nanosheet.

A plurality of source/drain patterns 121 and 122 may be provided on the first active pattern AP1. A plurality of first recesses may be formed on the upper portion of the first active pattern AP1. The source/drain patterns 121 and 122 may be provided in the first recesses, respectively. The source/drain patterns 121 and 122 may be impurity regions of a first conductivity type (e.g., n-type). A channel pattern CH may be interposed between a pair of source/drain patterns 121 and 122. For example, the stacked first and second semiconductor patterns may connect a pair of source/drain patterns 121 and 122 to each other.

Gate electrodes GE extending in a first direction D1 across the channel patterns CH may be provided. The gate electrodes GE may be disposed in a second direction D2 by a first pitch. Each of the gate electrodes GE may vertically overlap the channel patterns CH.

The gate electrode GE may include a first inner electrode interposed between the active pattern AP1 or AP2 and the first semiconductor pattern, a second inner electrode interposed between the first semiconductor pattern and the second semiconductor pattern, and an outer electrode on the second semiconductor pattern.

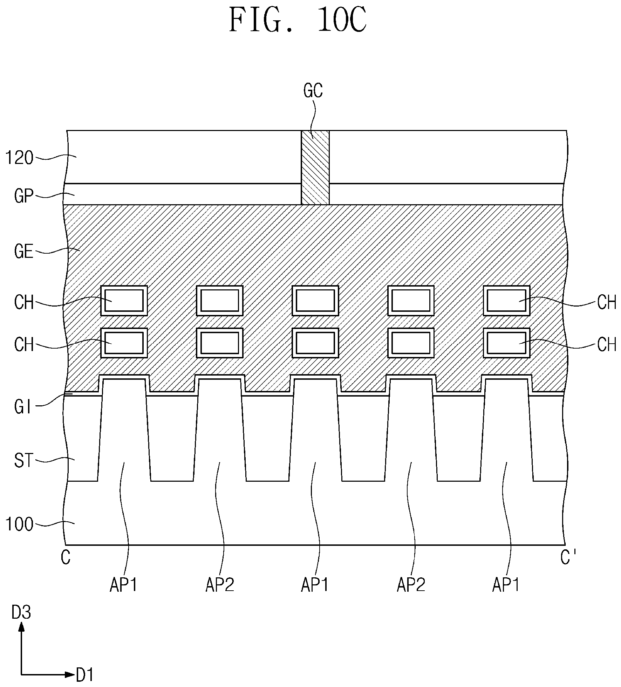

Referring again to FIG. 10C, the gate electrode GE may be provided on a top surface, a bottom surface, and both sidewalls of each of the first and second semiconductor patterns. In other words, the transistor according to the present embodiment may be a three-dimensional field effect transistor (e.g., MBCFET^{™} and/or GAAFET) in which the gate electrode GE three-dimensionally surrounds the channel.

The gate electrode GE may include a first metal pattern and a second metal pattern on the first metal pattern. The first metal pattern may be provided on the gate dielectric layer GI and may be adjacent to the first and second semiconductor patterns. The first metal pattern may include a work function metal that controls a threshold voltage of the transistor. A desired threshold voltage of the transistor may be achieved as the thickness and composition of the first metal pattern are adjusted. For example, the first and second inner electrodes of the gate electrode GE may be formed of a first metal pattern that is a work function metal.

The first metal pattern may include a metal nitride layer. For example, the first metal pattern may include at least one metal selected from the group consisting of titanium (Ti), tantalum (Ta), aluminum (Al), tungsten (W), and molybdenum (Mo) and nitrogen (N). Furthermore, the first metal pattern may further include carbon (C). The first metal pattern may include a plurality of stacked work function metal layers.

The second metal pattern may include a metal having lower resistance than that of the first metal pattern. For example, the second metal pattern may include at least one metal selected from the group consisting of tungsten (W), aluminum (Al), titanium (Ti), and tantalum (Ta). For example, the outer electrode of the gate electrode GE may include the first metal pattern and the second metal pattern on the first metal pattern.

Referring to FIGS. 9 and 10A, inner spacers IP may be provided on the first active pattern AP1. The inner spacers IP may be interposed between the first and second inner electrodes of the gate electrode GE and the source/drain pattern 121 or 122, respectively. The inner spacers IP may be in direct contact with the source/drain pattern 121 or 122. Each of the first and second inner electrodes of the gate electrode GE may be spaced apart from the source/drain pattern 121 or 122 by an inner spacer IP.

According to some example embodiments, some of the active fins on the ESD cell region may be removed, and the overcurrent flowing in the ESD device may be prevented from or reduced in likelihood of being concentrated in the certain region. For example, the overcurrent concentrated in the center region due to the layout of the ESD device may be dispersed, and thus the performance of the degraded ESD device may be improved. Alternatively or additionally, the current interference phenomenon between the active fins may be prevented or reduced, thereby reducing the region where the performance of the ESD device is vulnerable, and improving the thermal uniformity. Therefore, the reliability of the semiconductor device may be improved.

While some example embodiments have been described, a person of ordinary skill in the art may understand that many modifications and variations are made without departing from the scope of the present disclosure defined in the following claims. Accordingly, example embodiments should be considered in all respects as illustrative and not restrictive, with the scope of inventive concepts being indicated by the appended claims. Additionally, example embodiments are not necessarily mutually exclusive with one another. For example, some example embodiments may include one or more features described with reference to one or more figures, and may also include one or more other features described with reference to one or more other figures.

## Claims

1. A semiconductor device comprising:
a substrate (100) including a logic cell region and an electrostatic discharge, ESD, cell region;
a plurality of active fins (AF1, AF2) on the ESD cell region alternating in a first direction (D1), the plurality of active fins (AF1, AF2) including first active fins (AF1) and second active fins (AF2) alternating and spaced apart in the first direction (D1);
a device isolation layer (ST) defining the first active fins (AF1) and the second active fins (AF2);
a pair of source/drain patterns (121, 122) on each of the plurality of active fins (AF1, AF2) and spaced apart from each other in a second direction (D2) intersecting the first direction (D1);
a channel pattern (CH) between the pair of source/drain patterns (121, 122); and
a gate electrode (GE) extending in the first direction (D1) on the channel pattern (CH), wherein
each of the first (AF1) and second (AF2) active fins extend in the second direction (D2), and
a length of the first active fin (AF1) in the second direction (D2) is greater than a length of the second active fin (AF2) in the second direction (D2).

2. The semiconductor device of claim 1, wherein the length of the first active fin (AF1) in the second direction (D2) is 1.5 to 3.5 times the length of the second active fin (AF2) in the second direction (D2).

3. The semiconductor device of claim 1 or 2, further comprising:
a first portion of a N+ emitter region (121), a first portion of a P+ base region (140), an N collector region (122), a second portion of the P+ base region (140), and a second portion of the N+ emitter region (121) sequentially arranged in the second direction (D2) on each of the first active fins (AF1).

4. The semiconductor device of any preceding claim, further comprising:
a first N+ emitter region (121), a first portion of a P+ base region (140), an N collector region (122), a second portion of the P+ base region (140), and a second N+ emitter region (121_C) sequentially arranged in the second direction (D2) on each of the second active fins (AF2).

5. The semiconductor device of any preceding claim, further comprising:
a third active fin (AF2) spaced apart from each of the second active fins (AF2) by a certain distance in the second direction (D2).

6. The semiconductor device of claim 5, further comprising:
a first N+ emitter region (121), a first portion of a first P+ base region (140), a first N collector region (122), a second portion of the first P+ base region (140), and a second N+ emitter region (121_C) sequentially arranged in the second direction (D2) on each of the second active fins (AF2); and
a third N+ emitter region (121_C), a second portion of a second P+ base region (140), a second N collector region (122), a first portion of the second P+ base region (140), and a fourth N+ emitter region (121) sequentially disposed in the second direction (D2) on each of the third active fins (AF2).

7. The semiconductor device of claim 6, wherein
a width of the second N+ emitter region (121_C) on each of the second active fins (AF2) in the second direction (D2) is less than a width of the first N+ emitter region (121) on each of the second active fins (AF2) in the second direction (D2), and
a width of the third N+ emitter region (121_C) on the third active fin (AF2) in the second direction (D2) is less than a width of the fourth N+ emitter region (121) on each of the third active fins (AF2) in the second direction (D2).

8. The semiconductor device of any preceding claim, further comprising:
an NPN bipolar transistor on each of the first active fins (AF1).

9. The semiconductor device of any preceding claim, wherein
a distance between one of the first active fins (AF1) and one of the second active fins (AF2) is a first width (W1), and
a distance between adjacent first active fins (AF1) among the first active fins (AF1) is a second width (W2), different from the first width (W1).

10. The semiconductor device of claim 9, wherein the second width (W2) is greater than the first width (W1).

11. The semiconductor device of any preceding claim, further comprising:
an active contact (AC) electrically connected to each of the pair of source/drain patterns (121, 122); and
a gate contact (GC) electrically connected to the gate electrode (GE).

12. The semiconductor device of any preceding claim, wherein an active contact connected (AC) to the pair of source/drain patterns (121, 122) and a gate contact (GC) connected to the gate electrode (GE) are not provided in at least a portion of the ESD cell region.

13. A semiconductor device comprising:
a substrate (100) including an electrostatic discharge, ESD, cell region;
a plurality of active fins (AF1, AF2) on the ESD cell region and spaced apart from each other in a first direction (D1);
a device isolation layer (ST) defining each of the plurality of active fins (AF1, AF2);
a pair of source/drain patterns (121, 122) on each of the plurality of active fins (AF1, AF2) and spaced apart from each other in a second direction (D2) intersecting the first direction (D1);
a channel pattern (CH) between the pair of source/drain patterns (121, 122); and
a gate electrode (GE) extending in the first direction (D1) on the channel pattern (CH), wherein
the plurality of active fins (AF1, AF2) include first active fins (AF1) and second active fins (AF2), and
at least one of the second active fins (AF2) is between the first active fins (AF1).

14. The semiconductor device of claim 13, wherein
a distance between one of the first active fins (AF1) and one of the second active fins (AF2) is a first width (W1),
in response to one of the second active fins (AF2) being between the first active fins (AF1), a distance between the neighboring first active fins (AF1) among the first active fins (AF1) is a second width (W2) different from the first width (W1), and
in response to two of the second active fins (AF2) being between the first active fins (AF1), a distance between the neighboring first active fins (AF1) among the first active fins (AF1) is a third width (W3) different from the first width (W1).

15. The semiconductor device of claim 14, wherein the third width (W3) is greater than the first width (W1) and the second width (W2).
